# FASCICULE DE BREVET EUROPEEN

(11) **EP 3 985 456 B1**
(45) Date de publication et mention de la délivrance du brevet: **05.08.2026**
(21) Numéro de dépôt: 21183278.7
(22) Date de dépôt: 20.12.2012
(51) Int. Cl.: G04F 5/06, G04G 17/02, B81C 1/00, G04B 17/06, G04C 3/12, G02B 6/12, B23K 26/00, G04B 17/34

(54) **PROCÉDÉ DE RÉALISATION D'UN RÉSONATEUR**
VERFAHREN ZUR HERSTELLUNG EINES RESONATORS
METHOD FOR MANUFACTURING A RESONATOR

(30) Priorité: 22.12.2011 EP 11195420
(43) Date de publication de la demande: 20.04.2022
(62) Demande divisionnaire de: 12812966.5
(73) Titulaire: The Swatch Group Research and Development Ltd, 2074 Marin (CH)
(72) Inventeur: Hessler, Thierry, 2024 St-Aubin (CH); Dalla Piazza, Silvio, 2610 St-Imier (CH)
(74) Mandataire: ICB SA

(56) Documents cités:
- JP-A- 2010 183 138
- US-A1- 2002 139 769
- US-A1- 2003 235 385
- US-A1- 2007 115 079
- US-A1- 2011 034 031
- US-A1- 2011 127 883

## Description

L'invention concerne un résonateur comportant un corps utilisé en déformation comme un résonateur spiral ou un diapason.

### ARRIERE PLAN TECHNOLOGIQUE

Il est connu de l'art antérieur que certaines pièces de microtechnique en matériaux de type monocristallin ou polycristallin, comme des résonateurs, sont réalisées par gravure chimique. Cette technique consiste à se munir du substrat à graver et à déposer une couche de résine photosensible dessus. Sur cette résine est placé un masque puis le tout est exposé à de la lumière afin que la structure de la résine photosensible exposée à la lumière soit modifiée. Cette résine modifiée est éliminée par action d'un élément chimique laissant alors à nu, aux endroits où la résine a été éliminée, le substrat.

Par la suite, ces zones à nu du substrat sont attaquées chimiquement afin de les creuser. L'agent chimique est choisi pour attaquer seulement le matériau composant le substrat et non la résine photosensible non modifiée. La durée de cette étape de gravure chimique permet de déterminer les dimensions des creusures.

De même, il est envisageable que des pièces de microtechnique soient réalisées par usinage et/ou polissage de sorte qu'un foret ou une polisseuse puissent être utilisés pour façonner lesdites pièces.

Un premier inconvénient de cette technique de gravure chimique est qu'elle ne permet pas de réaliser des creusures avec des flancs droits. En effet, les creusures obtenues présentent des flancs inclinés. On entend par là que la surface de la creusure varie en fonction de la profondeur c'est-à-dire que cette surface s'agrandit ou se rétrécit au fur et à mesure que la creusure devient profonde. Généralement cette surface rétrécit avec la profondeur. Cette constatation oblige à adapter les calculs théoriques réalisés pour obtenir des creusures à flancs droits. De plus, cette variation du profil des creusures entre la théorie et la pratique entraîne une variation des caractéristiques.

La demande de brevet JP-2010-183138 A divulgue à ce titre un résonateur conforme à l'état de l'art antérieur et comprenant une base à partir de laquelle s'étendent deux bras parallèles avec un évidement.

### RESUME DE L'INVENTION

L'invention a pour but de pallier aux inconvénients cités ci-devant en proposant un procédé de fabrication permettant de réaliser un composant comprenant des creusures dont les flancs ont une inclinaison facilement réalisable.

A cet effet, l'invention concerne un procédé de fabrication selon la revendication 1.

Un avantage de la présente invention est de permettre de réaliser des évidements se situant sous la surface car le matériau utilisé est choisi comme étant transparent pour le laser. Cela permet au laser de pouvoir pointer n'importe quel point de la surface ou sous la surface du résonateur. Le matériau est alors rendu sélectif de sorte que l'attaque chimique qui suit n'opère que sur le matériau ayant subit une modification par le laser. On obtient alors un procédé qui permet de réaliser des évidements complexes et internes.

Des modes de réalisation avantageux du procédé selon la présente invention font l'objet de revendications dépendantes.

Dans un premier mode de réalisation avantageux, le procédé comprend en outre l'étape :
c) libérer le composant dudit substrat.

Dans un mode de réalisation avantageux, le substrat est réalisé en matériau monocristallin.

Dans un autre mode de réalisation avantageux, le substrat est réalisé en matériau polycristallin.

Dans un autre mode de réalisation avantageux, le substrat est réalisé en un matériau amorphe comme une céramique ou un verre.

Dans un autre mode de réalisation avantageux, le substrat est réalisé en polymère.

Selon l'invention, ledit au moins un évidement se présente sous la forme d'une gorge ayant au moins un de ses flancs verticaux.

Dans un autre mode de réalisation avantageux, ledit résonateur comprend une gorge par bras.

Dans un autre mode de réalisation avantageux, ledit résonateur comprend une gorge sur la face supérieure de chaque bras et une gorge sur la face inférieure de chaque bras.

Dans un autre mode de réalisation avantageux, ledit résonateur comprend deux gorges par bras.

Dans un autre mode de réalisation avantageux, ledit résonateur comprend deux gorges sur la face supérieure de chaque bras et deux gorges sur la face inférieure de chaque bras.

Dans un autre mode de réalisation avantageux, il comprend en outre une étape consistant à modifier la structure du résonateur par laser de sorte à modifier localement l'indice de réfraction de la matière.

Dans un autre mode de réalisation avantageux, ledit corps est réalisé en quartz ou céramique ou verre et en ce qu'il comprend des flancs localement parallèles et verticaux sur toute la longueur dudit corps.

Dans un autre mode de réalisation avantageux, ledit corps transmet et diffuse de la lumière émise par au moins une source d'énergie lumineuse.

Dans un premier mode de réalisation avantageux, l'une des faces de l'un des au moins deux bras parallèles comprend au moins un évidement se présentant sous la forme d'une gorge présentant des flancs verticaux.

Dans un second mode de réalisation avantageux, ledit résonateur comprend une gorge par bras.

Dans un troisième mode de réalisation avantageux, ledit résonateur comprend une gorge sur la face supérieure de chaque bras et une gorge sur la face inférieure de chaque bras.

Dans un autre mode de réalisation avantageux, ledit résonateur comprend deux gorges par bras.

Dans un autre mode de réalisation avantageux, ledit résonateur comprend deux gorges sur la face supérieure de chaque bras et deux gorges sur la face inférieure de chaque bras.

Dans un autre mode de réalisation avantageux, les gorges comprennent une saillie qui permet d'optimiser les champs électriques, tout en augmentant les tolérances d'alignement.

Dans un autre mode de réalisation avantageux, la totalité des flancs dudit résonateur sont droits et verticaux.

Dans un autre mode de réalisation avantageux, la totalité des angles dudit résonateur sont droits.

Dans un autre mode de réalisation avantageux, la totalité des angles dudit résonateur sont vifs.

Dans un mode de réalisation avantageux, ladite au moins une creusure comprend au moins deux flancs parallèles.

### BREVE DESCRIPTION DES FIGURES

Les buts, avantages et caractéristiques du procédé selon la présente invention apparaîtront plus clairement dans la description détaillée suivante de formes de réalisation de l'invention données uniquement à titre d'exemple non limitatif et illustrées par les dessins annexés sur lesquels :
- Les figures 1 et 2 représentent de manière schématique une vue de face d'un résonateur selon l'art antérieur ;
- Les figures 3a à 3e représentent de manière schématique les étapes du procédé selon la présente invention;
- Les figures 4 et 5 représentent de manière schématique une première forme d'exécution du résonateur selon la présente invention ;
- La figure 6 représente de manière schématique une variante de la première forme d'exécution du résonateur selon la présente invention ;
- La figure 7 représente de manière schématique une deuxième forme d'exécution du résonateur selon la présente invention;
- Les figures 8 et 9 représentent de manière schématique une première variante de la seconde forme d'exécution du résonateur selon la présente invention;
- La figure 10 représente de manière schématique une seconde variante de la seconde forme d'exécution du résonateur selon la présente invention ;
- La figure 11 représente de manière schématique une troisième forme d'exécution du résonateur selon la présente invention ; et
- La figure 12 représente de manière schématique une variante de la première forme d'exécution du résonateur selon la présente invention.

### DESCRIPTION DETAILLEE

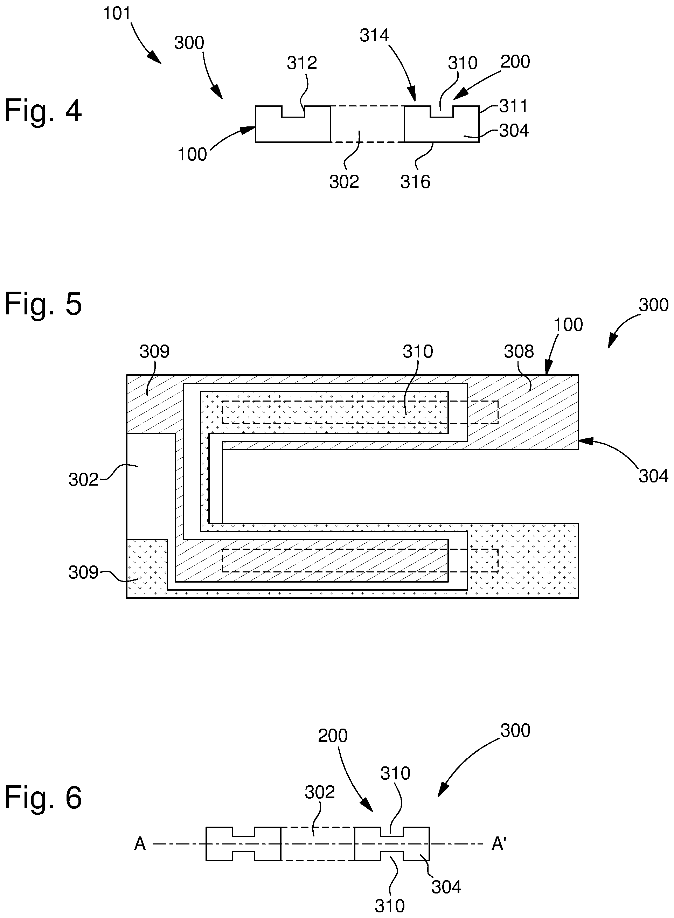

Les figures 4 et 5 représentent de manière schématique un composant selon la présente invention.

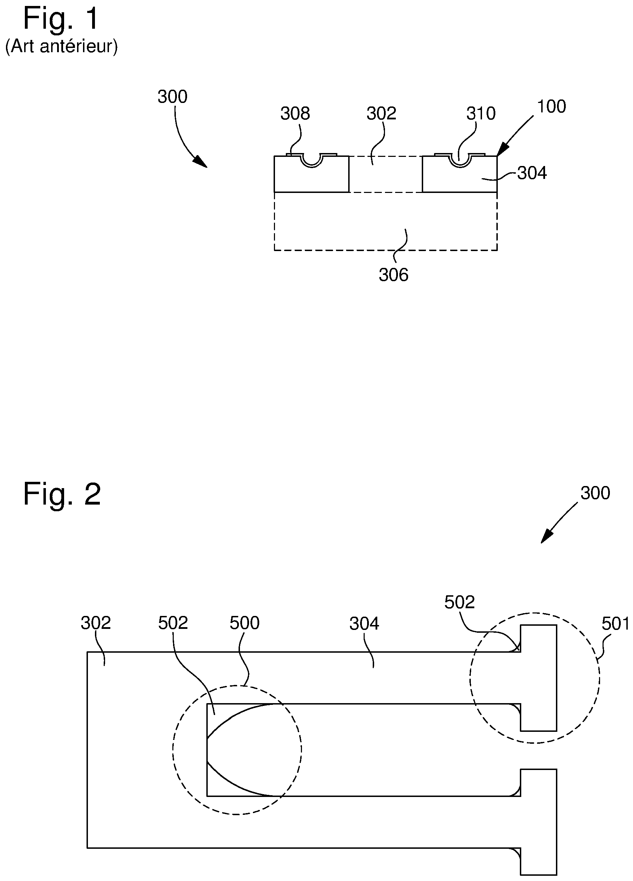

Le composant 101 fabriqué avec le procédé selon la présente invention est un résonateur 300. Un résonateur classique visible à la figure 1 comprend un corps 100 utilisé en déformation. Ce corps 100 prend la forme d'une base 302 posée sur un socle 306 et à partir de laquelle s'étendent au moins deux bras parallèles 304. Ces deux bras parallèles 304 portent des métallisations qui forment, sur ces branches, deux groupes d'électrodes 308 qui permettent de les soumettre à des champs électriques pour les faire vibrer. Le résonateur 300 comprend en outre, sur la base 302, des plages de connexion 309 reliées respectivement aux groupes d'électrodes 308 comme visible à la figure 5. Chaque bras 304 comprend une face supérieure 314 et une face inférieure 316. Les dimensions typiques d'un tel résonateur 300 sont une longueur de 1mm, une largeur de 0.1 mm et une épaisseur de 0.1mm, Le résonateur comprend en outre des flancs 311.

Afin d'améliorer les caractéristiques du résonateur 300, il est connu de réaliser des évidements 200 se présentant sous la forme de gorges 310 ou rainures et situés sur ces bras 304. Ces gorges 310 augmentent le couplage piézoélectrique, ce qui permet une diminution de la consommation électrique. Cette diminution de la consommation est une conséquence de la diminution de la résistance électrique représentant les pertes dans le schéma équivalent du résonateur 300.

Pour réaliser les gorges 310 du composant 101, la présente invention se propose de fournir un procédé de fabrication. Dans le cas présent, l'accent sera mis sur la réalisation des gorges 310 ou évidements 200.

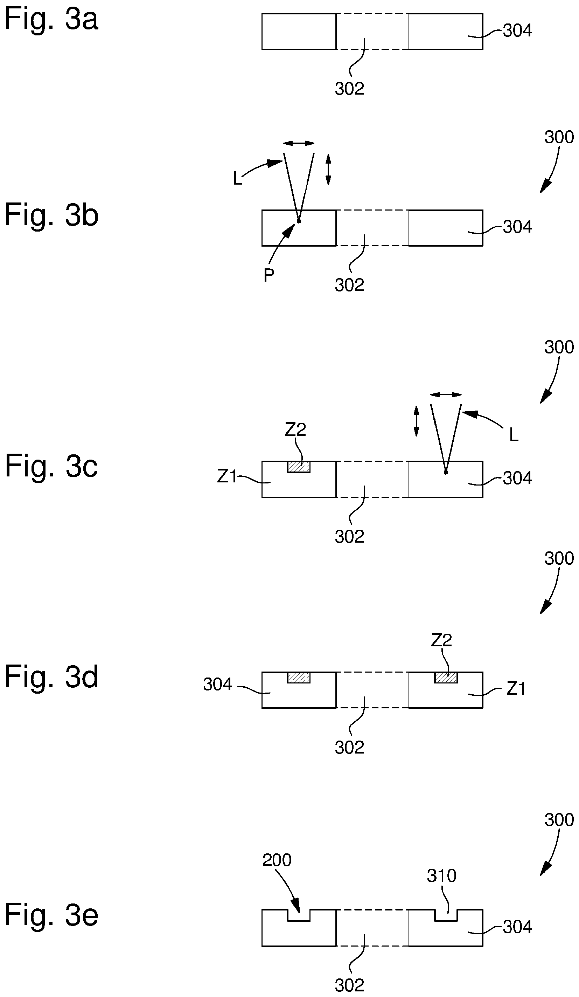

Dans une première étape représentée à la figure 3a, on se munit du composant 101, ici le résonateur 300, sans que les gorges 310 ne soient réalisées. On comprend alors que ce résonateur 300 est préalablement réalisé. Ce résonateur 300 est réalisé selon la méthode la plus appropriée en fonction du matériau le constituant, appelé ici premier matériau, comme par exemple l'usinage ou la gravure chimique.

Une seconde étape consiste à se munir d'un laser (L) dont la durée des impulsions est ici de l'ordre de la femto-seconde c'est-à-dire 10⁻¹⁵ seconde (typiquement 100 fs). La durée des impulsions peut aller de la femtoseconde à la picoseconde (10⁻¹² seconde). Ce laser (L) est ensuite utilisé afin de modifier la structure dudit bras 304 comme visible à la figure 3b. A cet effet, le premier matériau est choisi comme étant transparent pour le laser. Cela permet de pointer, avec le point de focalisation (P) du laser (L), un point (P) qui peut se trouver sur ou sous la surface du bras 304. Pour le laser (L) dont la durée des impulsions est ici de l'ordre de la femto-seconde, le premier matériau peut être un matériau monocristallin comme le quartz, le saphir ou le rubis synthétique, ou un matériau polycristallin comme le rubis polycristallin ou un matériau amorphe comme un verre tel que la silice ou une céramique. Le point de focalisation (P) est ensuite pointé en direction du résonateur 300 au niveau de zones situées sur ou sous la surface du résonateur 300. Tout cela est fait selon une séquence prédéterminée ou désirée afin de provoquer localement une modification de la structure par absorption à plusieurs photons. **En** effet, la modification de la structure du matériau par absorption à plusieurs photons nécessite une densité d'énergie très élevée. Or, obtenir une telle densité d'énergie nécessaire n'est actuellement possible qu'avec des lasers dont la durée des impulsions est très faible, c'est-à-dire, de l'ordre de la femto-seconde ou de la pico-seconde. Ces lasers sont, en effet, capables de fournir cette densité d'énergie au point de focalisation c'est-à-dire là ou la densité d'énergie est la plus importante. On modifie alors la structure d'un premier bras 304 comme visible à la figure 3c et on s'occupe de l'autre bras 304. On obtient alors le résonateur 300 tel que visible à la figure 3d.

La troisième étape consiste à se munir d'un agent chimique. Cet agent chimique est choisi pour permettre aux zones Z1 dont la structure est modifiée, d'être dissoutes plus rapidement que les zones Z2 dont la structure n'a pas été modifiée. On entend par là que la vitesse d'attaque des zones Z1 dont la structure a été modifiée par le point de focalisation (P) du laser (L) est supérieure à la vitesse d'attaque des zones Z2 dont la structure n'a pas été modifiée par le laser (L). En effet, la modification locale de la structure par le point de focalisation (P) du laser (L) femtoseconde permet de choisir un agent chimique qui est plus réactif aux zones modifiées Z1 qu'aux zones non modifiées Z2. **En** conséquence, en plongeant, durant un temps déterminé, ledit résonateur dans un bain composé de l'agent chimique, on fait en sorte que toutes les zones Z1 dont la structure a été modifiée par le point de focalisation (P) du laser (L) soient dissoutes. Bien entendu, les dimensions du résonateur 300 sont calculées pour prendre en compte l'attaque chimique de l'agent chimique sur les zones non modifiées et ainsi ne pas dissoudre excessivement les zones dont la structure n'est pas modifiée. On obtient alors le résonateur 300 visible à la figure 3e.

Par ailleurs, on notera que pour que la dissolution des zones Z1 dont la structure été modifiée se fasse, il est nécessaire que les zones Z1 puissent être accessibles pour l'agent chimique. On comprend donc qu'au moins une surface ou au moins une zone Z1 proche de la surface soit modifiée. **En** effet, le présent procédé permet de réaliser des structures internes mais nécessite que l'agent chimique puisse avoir accès aux zones Z1 dont la structure est modifiée. Avec une zone Z1 dont la structure est modifiée en surface, on permet audit agent chimique de dissoudre directement les zones modifiées Z1. Néanmoins, il est envisageable que les zones Z1 dont la structure a été modifiée ne soit pas situées à la surface mais juste sous la surface. L'agent chimique dissout alors le peu de zones Z2 non modifiées séparant ledit agent chimique des zones modifiées Z1 pour permettre ensuite la dissolution de celles-ci. Bien entendu, chaque évidement 200 du résonateur 300 devra être configuré de la sorte ou doivent être joints. Une fois toutes les zones modifiées Z1 dissoutes, ledit résonateur est sorti du bain.

Une quatrième étape consiste à nettoyer ledit résonateur afin que tous les résidus d'agent chimique soient éliminés. Cela permet que la réaction chimique soit définitivement stoppée.

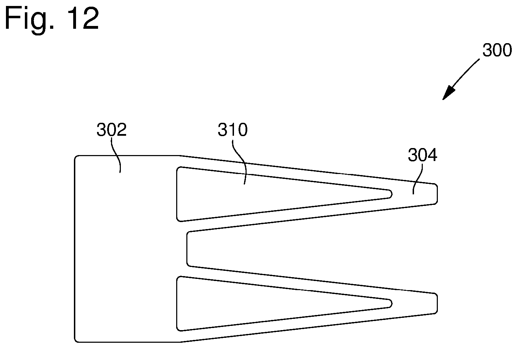

L'avantage du procédé selon la présente invention est double. En effet, ce procédé permet de modifier localement la structure du matériau du composant de sorte que chaque endroit en surface ou sous la surface du composant peut être structurellement modifié. Il est donc possible de modifier structurellement le résonateur 300 selon des formes complexes qui seront gravées chimiquement de façon précise. Par exemple, il est envisageable d'avoir des bras de forme trapézoïdale comme visible à la figure 12.

Cette possibilité de formes complexes est alors utilisée pour réaliser des flancs 311 et des creusures 310 ayant des flancs 312 droits et verticaux. Effectivement, les zones modifiées Z2 sont agencées pour prévoir ces flancs 312 droits et comme l'étape de gravure chimique n'agit que sur les zones modifiées, la verticalité des flancs 312 est gardée. On peut généraliser en disant que l'avantage du présent procédé est de préserver les formes d'origines des évidements 200. La présence des flancs 312 droits et verticaux permet d'améliorer le couplage piézoélectrique. En effet, ces flancs 312 entraînent une augmentation de la capacité motionnelle du résonateur 300. Or, cette capacité motionnelle représente l'efficacité du couplage piézoélectrique. Pour le résonateur 300 représenté à la figure 4, l'augmentation du gain en couplage piézoélectrique est de l'ordre de 30%.

Dans une première forme d'exécution visible aux figures 4 et 5, le résonateur reprend le modèle du résonateur 300 de l'art antérieur c'est-à-dire qu'il comprend deux gorges 310. Ces deux gorges 310 sont situées chacune sur la face supérieure 314 d'un des bras 304. Chaque bras 304 comprend alors une gorge 310. De préférence, la gorge 310 de chaque bras 304 est placée de façon centrée comme visible à la figure 4. Ces gorges 310 pouvant ainsi être de la même forme que celle des bras c'est-à-dire trapézoïdale dans le cas de la figure 12.

Dans une variante de cette première forme d'exécution de l'invention, chaque face 314, 316 de chaque bras 304 comporte une gorge 310. On comprend que pour un résonateur 300 ayant deux bras 304, ledit résonateur 300 comprend quatre gorges 310. On dénombre alors une gorge 310 sur la face supérieure 314 de chaque bras 304 et une gorge 310 sur la face inférieure 316 de chaque bras 304. Dans cette variante, les gorges 310 de chaque bras 304 sont opposées par rapport au plan A-A' visible à la figure 6.

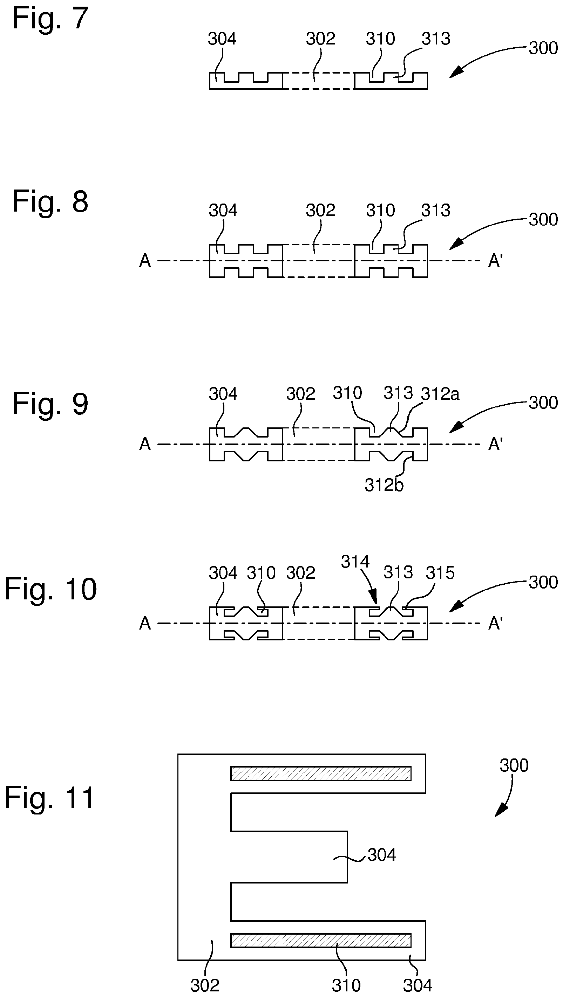

Dans une deuxième forme d'exécution, il est prévu d'avoir au moins deux gorges 310 sur l'une des faces 314, 316 de chaque bras 304 comme visible à la figure 7. De préférence, les au moins deux gorges 310 d'un bras 304 sont placées sur la même face 314, 316 que les au moins deux gorges 310 de l'autre bras 304. Cette disposition permet d'optimiser les champs électriques dans le résonateur 300.

Cette deuxième forme d'exécution peut avoir une variante en ce que chaque face 314, 316 de chaque bras 304 comprend au moins deux gorges 310 comme visible à la figure 8.

Cette variante peut consister à avoir deux rainures comprenant chacune un flanc droit 312b et un flanc incliné 312a, ces deux gorges 310 étant séparées par un élément central 313 comme visible à la figure 9. Ces rainures sont agencées de sorte que l'élément central 313 soit formé par les flancs inclinés 312a des deux gorges 310. Ces flancs 312a ont inclinés de sorte que la surface de la gorge 310 diminue lorsque la profondeur augmente. Cette disposition permet de profiter des flancs droits 312b des gorges 310 pour augmenter le couplage. De plus, le fait d'avoir deux petites gorges 310 au lieu d'une gorge 310 très large permet de ne pas enlever trop de matière au résonateur 300 et ainsi de moins le fragiliser.

Cette deuxième forme d'exécution et sa variante ont également l'avantage de permettre de raccourcir la durée du procédé car il y a moins de matière à enlever et donc moins de matière à modifier avec le laser (L).

Néanmoins, pour réaliser cette deuxième forme d'exécution, il est possible d'utiliser le procédé selon l'invention d'une autre façon. En effet, il a été décrit que le procédé utilise un laser (L) dont la durée des impulsions est de l'ordre de la femto-seconde pour modifier des zones du résonateur 300 et les dissoudre par action chimique. Or, il est également possible d'utiliser le laser (L) pour découper le résonateur 300. Le laser (L) est utilisé pour modifier les contours d'une zone à supprimer. L'étape de gravure chimique est alors effectuée et cela permet de dissoudre les contours de la zone à supprimer. Comme les contours de cette dernière sont dissous par l'action de l'agent chimique, la zone à supprimer se détache du résonateur 300. On peut alors sculpter la surface du résonateur 300 et enlever une partie de celui-ci, pour faire par exemple les gorges 310, sans modifier la structure de toute cette partie. Le gain de temps est, par conséquent, significatif.

Dans une seconde variante visible à la figure 10, chaque gorge 310 comprend une portion relativement grande en surface 314. Ces portions en surface 314 se présentent sous la forme d'une saillie 315 située à la surface du résonateur 300. Cette saillie 315 présente un profil rectangulaire et s'étend en direction du centre des bras. Cet agencement permet, outre les avantages d'avoir un champ électrique optimisé, d'améliorer l'alignement des masques. En effet, dans le cas de cette deuxième forme d'exécution, les portions en surface 314 sont utilisées pour augmenter la distance entre les électrodes 308 latérales et celles placées au centre des bras du diapason. On obtient alors une plus grande précision ou tolérance d'alignement des différents masques et donc une augmentation de la fiabilité et du rendement du procédé. On comprend donc que le résonateur, les gorges 310 et les portions en surface 314 sont réalisés préalablement à l'étape de réalisation des électrodes. La méthode selon la présente invention permet d'utiliser une méthode de masquage par ombrage ou par spray photosensible.

Dans une troisième forme d'exécution visible à la figure 11, il est possible que le résonateur 300 comprenne un troisième bras 304 de sorte que le résonateur 300 ait une forme similaire à celle d'un trident. Ce troisième bras 304 est utilisé pour la fixation du résonateur 300 et plus particulièrement pour modifier son centre de gravité. **En** effet, ce troisième bras 304 est utilisé comme point de fixation de sorte qu'il soit en contact du socle 306 soutenant le résonateur 300. Cette disposition du troisième bras 304 qui fait office de bras central 304 permet de positionner le centre de gravité et afin d'avoir le meilleur équilibre du résonateur 300. Bien entendu, ce résonateur 300 à trois bras 304 peut être agencé pour présenter une forme qui ressemble sensiblement à celle de la lettre W ou de la lettre M.

Avantageusement, le procédé selon la présente invention peut ne pas être utilisé que pour réaliser les gorges 310 des bras 304 du résonateur 300. En effet, comme le procédé selon la présente invention est précis et permet de réaliser des formes complexes, son utilisation pour réaliser une partie ou la totalité du résonateur 300 à partir d'un substrat est également envisageable. Cette possibilité de réaliser tout le résonateur 300 avec le procédé selon la présente invention est avantageuse car elle permet de raccourcir la durée du procédé. L'utilisation de ce procédé permet de réaliser, en une seule étape, l'étape de réalisation des contours et l'étape de réalisation des gorges 310 du résonateur 300. Bien entendu, on comprendra que cette façon de faire est aussi utilisable pour le cas d'un résonateur 300 standard à deux bras 304. Par ailleurs, il est envisageable que le procédé selon la présente invention ne soit utilisé que pour réaliser un résonateur 300 à deux ou trois bras 304 ne présentant pas de gorges 310 sur l'un et/ou l'autre des bras 304. Un autre avantage de cette technique réside dans la possibilité de s'affranchir des résidus de gravure chimique entre les deux bras et, quand des palmes sont agencées au bout des bras 304, à la base des palmes.

En effet, la gravure chimique par photolithographie et attaque chimique présente l'inconvénient d'être peu précise car l'attaque chimique ne se contrôle pas parfaitement. De ce fait, il est constaté qu'au niveau des certaines parties d'une pièce à réaliser du type résonateur, des résidus de gravure subsistent. Par exemple, on constate sur la figure 2 représentant un résonateur réalisé par la méthode de photolithographie et gravure chimique, que des résidus de gravure 502 subsistent dans la zone 500 située entre les deux bras 304 ou à la base des palmes de la zone des palmes 501. Or, ces résidus peuvent entraîner un déséquilibre de la pièce puisque la répartition de matière n'est pas forcement parfaite.

Au contraire, avec le procédé selon l'invention, l'illumination des contours avec le laser femtoseconde est précise ce qui a pour avantage d'avoir une gravure précise et mieux contrôlable et ainsi d'équilibrer les bras. Il est alors possible d'obtenir un résonateur 300 dont tous les flancs 311, 312 sont droits et verticaux et dont tous les angles sont vifs peu importe qu'ils soient droits ou non comme visible à la figure 4.

On comprendra que diverses modifications et/ou améliorations et/ou combinaisons évidentes pour l'homme du métier peuvent être apportées aux différents modes de réalisation de l'invention exposée ci-dessus sans sortir du cadre de l'invention définie par les revendications annexées.

## Revendications

1. Procédé de fabrication d'un évidement sur un résonateur (300, 400) dans un substrat, ledit résonateur comprenant une base (302) à partir de laquelle s'étendent au moins deux bras parallèles (304) présentant chacun une face supérieure (314) et une face inférieure (316) et comprenant en outre au moins un évidement (310), le procédé comprenant une étape consistant à se munir d'un résonateur, tel qu'il comprend les étapes suivantes :
a) modifier la structure d'au moins une zone d'un bras du résonateur afin de rendre plus sélective ladite au moins une zone, la structure de ladite au moins une zone étant modifiée par un laser (L), dont la durée des impulsions va de la femtoseconde à la picoseconde ;
b) graver ladite au moins une zone afin de sélectivement fabriquer ledit au moins un évidement (310) réalisé sur l'une des faces de l'un des au moins deux bras parallèles (304), le procédé étant **caractérisé en ce que** ledit au moins un évidement (310) se présente sous la forme d'une gorge ayant au moins un de ses flancs (312) vertical.

2. Procédé selon les revendications 1, **caractérisé en ce que** ledit résonateur comprend une gorge (310) par bras.

3. Procédé selon les revendications 1, **caractérisé en ce que** ledit résonateur comprend une gorge (310) sur la face supérieure (314) de chaque bras et une gorge (310) sur la face inférieure (316) de chaque bras (304).

4. Procédé selon les revendications 1, **caractérisé en ce que** ledit résonateur comprend deux gorges (310) par bras.

5. Procédé selon les revendications 1, **caractérisé en ce que** ledit résonateur comprend deux gorges (310) sur la face supérieure de chaque bras et deux gorges (310) sur la face inférieure de chaque bras.

6. Procédé de fabrication selon l'une des revendications précédentes, **caractérisé en ce que** le substrat est réalisé en matériau transparent à la longueur d'onde du laser.

7. Procédé de fabrication selon la revendication 6, **caractérisé en ce que** le substrat est réalisé en matériau monocristallin.

8. Procédé de fabrication selon la revendication 6, **caractérisé en ce que** le substrat est réalisé en matériau polycristallin.

9. Procédé de fabrication selon la revendication 6, **caractérisé en ce que** le substrat est réalisé en polymère.

10. Procédé de fabrication selon la revendication 6, **caractérisé en ce que** le substrat est réalisé en un matériau amorphe comme une céramique ou un verre.

11. Résonateur (300) comprenant une base (302) à partir de laquelle s'étendent au moins deux bras parallèles (304) présentant chacun une face supérieure (314) et une face inférieure (316) et au moins un groupe d'électrodes situé sur un des au moins deux bras parallèles (304) pour exciter électriquement ledit un des au moins deux bras parallèles (304), le résonateur comprenant au moins deux flancs (311, 312) parallèles droits et verticaux, **caractérisé en ce que** l'une des faces de l'un des au moins deux bras parallèles (304) comprend au moins un évidement (310) se présentant sous la forme d'une gorge présentant des flancs (312) verticaux.

12. Résonateur selon la revendication 11, **caractérisé en ce que** ledit résonateur comprend une gorge (310) par bras.

13. Résonateur selon la revendication 11, **caractérisé en ce que** ledit résonateur comprend une gorge (310) sur la face supérieure de chaque bras et une gorge (310) sur la face inférieure de chaque bras.

14. Résonateur selon la revendication 11, **caractérisé en ce que** ledit résonateur comprend deux gorges (310) par bras.

15. Résonateur selon la revendication 11, **caractérisé en ce que** ledit résonateur comprend deux gorges (310) sur la face supérieure de chaque bras et deux gorges (310) sur la face inférieure de chaque bras.

16. Résonateur selon l'une des revendications 11 à 15, **caractérisé en ce que** les gorges comprennent une saillie (315) qui permet d'optimiser les champs électriques, tout en augmentant les tolérances d'alignement.

17. Résonateur selon l'une des revendications 11 à 16, **caractérisé en ce que** la totalité des flancs (311, 312) dudit résonateur sont droits et verticaux.

18. Résonateur selon l'une des revendications 11 à 17, **caractérisé en ce que** la totalité des angles dudit résonateur sont droits.

19. Résonateur selon l'une des revendications 11 à 17, **caractérisé en ce que** la totalité des angles dudit résonateur sont vifs.

## Patentansprüche

1. Verfahren zur Herstellung einer Aussparung an einem Resonator (300, 400) in einem Substrat, wobei der Resonator eine Basis (302) umfasst, von der sich mindestens zwei parallele Arme (304) erstrecken, die jeweils eine obere Fläche (314) und eine untere Fläche (316) aufweisen und ferner mindestens eine Aussparung (310) umfassen, wobei das Verfahren die folgenden Schritte umfasst:
a) Verändern der Struktur mindestens eines Bereichs eines Arms des Resonators, um den mindestens einen Bereich selektiver zu machen, wobei die Struktur des mindestens einen Bereichs durch einen Laser (L) verändert wird, dessen Impulsdauer von der Femtosekunde bis zur Pikosekunde reicht;
b) Ätzen des mindestens einen Bereichs, um selektiv die mindestens eine Aussparung (310) herzustellen, die auf einer der Flächen eines der mindestens zwei parallelen Arme (304) ausgebildet ist, wobei das Verfahren **dadurch gekennzeichnet ist, dass** sich die mindestens eine Aussparung (310) in Form einer Rille darstellt, bei der mindestens eine ihrer Flanken (312) vertikal verläuft.

2. Verfahren nach Anspruch 1, **dadurch gekennzeichnet, dass** der Resonator eine Rille (310) pro Arm umfasst.

3. Verfahren nach Anspruch 1, **dadurch gekennzeichnet, dass** der Resonator eine Rille (310) auf der oberen Fläche (314) jedes Arms und eine Rille (310) auf der unteren Fläche (316) jedes Arms (304) umfasst.

4. Verfahren nach Anspruch 1, **dadurch gekennzeichnet, dass** der Resonator zwei Rillen (310) pro Arm umfasst.

5. Verfahren nach Anspruch 1, **dadurch gekennzeichnet, dass** der Resonator zwei Rillen (310) auf der oberen Fläche jedes Arms und zwei Rillen (310) auf der unteren Fläche jedes Arms (304) umfasst.

6. Herstellungsverfahren nach einem der vorstehenden Ansprüche, **dadurch gekennzeichnet, dass** das Substrat aus einem Material besteht, das bei der Wellenlänge des Lasers transparent ist.

7. Herstellungsverfahren nach Anspruch 6, **dadurch gekennzeichnet, dass** das Substrat aus einem einkristallinen Material besteht.

8. Herstellungsverfahren nach Anspruch 6, **dadurch gekennzeichnet, dass** das Substrat aus einem polykristallinen Material besteht.

9. Herstellungsverfahren nach Anspruch 6, **dadurch gekennzeichnet, dass** das Substrat aus einem Polymer besteht.

10. Herstellungsverfahren nach Anspruch 6, **dadurch gekennzeichnet, dass** das Substrat aus einem amorphen Material wie Keramik oder Glas besteht.

11. Resonator (300) umfassend eine Basis (302), von der sich mindestens zwei parallele Arme (304) erstrecken, die jeweils eine obere Fläche (314) und eine untere Fläche (316) aufweisen, und mindestens eine Elektrodengruppe, die auf einem der mindestens zwei parallelen Arme (304) angeordnet ist, um den einen der mindestens zwei parallelen Arme (304) elektrisch anzuregen, wobei der Resonator mindestens zwei gerade parallele und vertikale Flanken (311, 312) umfasst, **dadurch gekennzeichnet, dass** eine der Flächen eines der mindestens zwei parallelen Arme (304) mindestens eine Aussparung (310) umfasst, die in Form einer Rille mit vertikalen Flanken (312) ausgebildet ist.

12. Resonator nach Anspruch 11, **dadurch gekennzeichnet, dass** der Resonator eine Rille (310) pro Arm umfasst.

13. Resonator nach Anspruch 11, **dadurch gekennzeichnet, dass** der Resonator eine Rille (310) auf der oberen Fläche jedes Arms und eine Rille (310) auf der unteren Fläche jedes Arms umfasst.

14. Resonator nach Anspruch 11, **dadurch gekennzeichnet, dass** der Resonator zwei Rillen (310) pro Arm umfasst.

15. Resonator nach Anspruch 11, **dadurch gekennzeichnet, dass** der Resonator zwei Rillen (310) auf der oberen Fläche jedes Arms und zwei Rillen (310) auf der unteren Fläche jedes Arms umfasst.

16. Resonator nach einem der Ansprüche 11 bis 15, **dadurch gekennzeichnet, dass** die Rillen einen Vorsprung (315) umfassen, der es ermöglicht, die elektrischen Felder zu optimieren, während gleichzeitig die Ausrichtungstoleranzen erhöht werden.

17. Resonator nach einem der Ansprüche 11 bis 16, **dadurch gekennzeichnet, dass** die Gesamtheit der Flanken (311, 312) des Resonators rechtwinklig und vertikal sind.

18. Resonator nach einem der Ansprüche 11 bis 17, **dadurch gekennzeichnet, dass** die Gesamtheit der Winkel des Resonators rechtwinklig sind.

19. Resonator nach einem der Ansprüche 11 bis 17, **dadurch gekennzeichnet, dass** die Gesamtheit der Winkel des Resonators spitz ist.

## Claims

1. Method for manufacturing a recess on a resonator (300, 400) in a substrate, said resonator comprising a base (302) from which extend at least two parallel arms (304), each having an upper face (314) and a lower face (316), and further comprising at least one recess (310), the method comprising a step consisting of preparing a resonator, such that it comprises the following steps:
a) modifying the structure of at least one zone of a resonator arm to make said at least one zone more selective, the structure of said at least one zone being modified by a laser (L) with impulse durations ranging from femtoseconds to picoseconds;
b) engraving said at least one zone to selectively manufacture said at least one recess (310) made on one of the faces of one of the at least two parallel arms (304), the method being **characterised in that** said at least one recess (310) is in the form of a groove with at least one vertical flank (312).

2. Method according to claim 1, **characterised in that** said resonator comprises one groove (310) per arm.

3. Method according to claim 1, **characterised in that** said resonator comprises a groove (310) on the upper face (314) of each arm and a groove (310) on the lower face (316) of each arm (304).

4. Method according to claim 1, **characterised in that** said resonator comprises two grooves (310) per arm.

5. Method according to claim 1, **characterised in that** said resonator comprises two grooves (310) on the upper face of each arm and two grooves (310) on the lower face of each arm.

6. Manufacturing method according to any of the preceding claims, **characterised in that** the substrate is made of a material that is transparent to the laser wavelength.

7. Manufacturing method according to claim 6, **characterised in that** the substrate is made of a single-crystal material.

8. Manufacturing method according to claim 6, **characterised in that** the substrate is made of a polycrystalline material.

9. Manufacturing method according to claim 6, **characterised in that** the substrate is made of a polymer.

10. Manufacturing method according to claim 6, **characterised in that** the substrate is made of an amorphous material such as ceramic or glass.

11. Resonator (300) comprising a base (302) from which extend at least two parallel arms (304), each having an upper face (314) and a lower face (316) and at least one group of electrodes located on one of the at least two parallel arms (304) for electrically exciting said one of the at least two parallel arms (304), the resonator comprising at least two straight, vertical, parallel flanks (311, 312), **characterised in that** one of the faces of one of the at least two parallel arms (304) comprises at least one recess (310) in the form of a groove with vertical flanks (312).

12. Resonator according to claim 11, **characterised in that** said resonator comprises one groove (310) per arm.

13. Resonator according to claim 11, **characterised in that** said resonator comprises a groove (310) on the upper face of each arm and a groove (310) on the lower face of each arm.

14. Resonator according to claim 11, **characterised in that** said resonator comprises two grooves (310) per arm.

15. Resonator according to claim 11, **characterised in that** said resonator comprises two grooves (310) on the upper face of each arm and two grooves (310) on the lower face of each arm.

16. Resonator according to any of claims 11 to 15, **characterised in that** the grooves comprise a protrusion (315) enabling the electric fields to be optimised whilst increasing the alignment tolerances.

17. Resonator according to any of claims 11 to 16, **characterised in that** all the flanks (311, 312) of said resonator are straight and vertical.

18. Resonator according to any of claims 11 to 17, **characterised in that** all the angles of said resonator are right angles.

19. Resonator according to any of claims 11 to 17, **characterised in that** all the angles of said resonator are acute angles.
